# EUROPÄISCHE PATENTSCHRIFT

(11) **EP 1 989 934 B1**
(45) Veröffentlichungstag und Bekanntmachung des Hinweises auf die Patenterteilung: **29.12.2010**
(21) Anmeldenummer: 07703754.7
(22) Anmeldetag: 10.01.2007
(51) Int. Cl.: H05K 7/12, H05K 7/14

(54) **ELEKTRISCHES GERÄT MIT EINEM AUF EINEM SCHALTUNGSTRÄGER ANGEORDNETEN KUNSTSTOFFSTECKERTEIL**
ELECTRICAL DEVICE WITH A PLASTIC PLUG PART DISPOSED ON A CIRCUIT SUPPORT
APPAREIL ÉLECTRIQUE PRÉSENTANT UN BLOC ENFICHABLE EN MATIÈRE PLASTIQUE DISPOSÉ SUR UN SUPPORT DE CIRCUITS

(30) Priorität: 02.03.2006 AT 3552006
(43) Veröffentlichungstag der Anmeldung: 12.11.2008
(73) Patentinhaber: MELECS EWS GmbH & Co KG, 7011 Siegendorf (AT)
(72) Erfinder: CHLUMSKY, Lubomir, A-1150 Wien (AT); HELLINGER, Leopold, A-3710 Ziersdorf (AT); KOCEVAR, Anton, A-3100 St. Pölten (AT); NEUMANN, Gerhard, A-3231 St. Margarethen (AT)
(74) Vertreter: Maier, Daniel Oliver
(86) Internationale Anmeldenummer: PCT/EP2007/050207
(87) Internationale Veröffentlichungsnummer: WO 2007/098972

(56) Entgegenhaltungen:
- EP-A1- 0 250 097
- JP-A- 2004 303 504
- US-A- 5 231 561

## Beschreibung

### Technisches Gebiet

Die Erfindung betrifft ein elektrisches Gerät, insbesondere ein Steuergerät für ein Kraftfahrzeug, mit einem auf einer metallischen Gehäusegrundplatte befestigtem plattenförmigen Schaltungsträger auf dem an einer von der Gehäusegrundplatte abgewandten Seite ein Kunststoffsteckerteil angeordnet ist.

### Stand der Technik

Elektrische Geräte, die in der Kraftfahrzeugtechnik beispielsweise zur Steuerung eines Getriebes eingesetzt werden, bestehen meist aus einem in einem Gehäuse untergebrachten plattenförmigen Schaltungsträger, der auf einer Gehäusegrundplatte befestigt ist. Der Anschluss eines Kabels erfolgt über ein Kunststoffsteckerteil, das durch eine Durchführung im Gehäuse herausgeführt ist. Die elektrischen Kontakte des Kunststoffsteckerteils sind mit Leiterbahnen auf dem Schaltungsträger verbunden. Eine solche Anordnung wird in USA-5231561 beschrieben.

Elektrische Geräte, die in einem Kraftfahrzeug eingesetzt sind, sind rauen Umgebungsbedingungen ausgesetzt. Bei Betrieb können hohe Beschleunigungskräfte auftreten. Dabei übertragen angeschlossene Kabel über das Steckerteil Vibrationen auf die Lötverbindungen im Inneren des Gehäuses. Schon geringe Wechselbeanspruchungen auf diese Lötverbindungen können die Zuverlässigkeit des elektronischen Gerätes empfindlich stören. Man ist deshalb bestrebt, die von einem Anschlusskabel eingeleiteten mechanischen Beanspruchungen von elektrischen Verbindungen, Lötverbindungen oder Leiterplatten-Steckverbindungen möglichst fern zu halten, das heißt die mechanische Verbindung zwischen dem Kunststoffsteckerteil, dem Schaltungsträger und der Gehäusegrundplatte ist konstruktiv möglichst stabil auszuführen.

Eine kostengünstige Ausführung für eine stabile Verbindung ist die Nietverbindung. Dabei tritt aber das Problem auf, dass, wenn das Kunststoffsteckerteil auf einer von der Gehäusegrundplatte abgewandten Seite des Schaltungsträgers angeordnet ist, das Kunststoffsteckerteil die für die Herstellung der Nietverbindung erforderlichen mechanischen Kräfte nicht schadlos aufnehmen kann. Es kann zu Rissen im Kunststoffsteckerteil kommen, die nach einer bestimmten Nutzungsdauer des Kraftfahrzeugs zum Bruch führen können. In weiterer Folge ist die elektrische Verbindung zwischen dem Anschlusskabel und den Leiterbahnen auf dem Schaltungsträger beeinträchtigt. Eine unzulängliche Befestigung des Kunststoffsteckerteils kann so den Ausfall des gesamten elektrischen Gerätes herbeiführen.

Um eine Beschädigung des Kunststoffsteckerteils zu vermeiden, wurden bislang gesonderte Befestigungsmittel vorgesehen, das heißt, für die Befestigung des Kunststoffsteckerteils auf dem Schaltungsträger z. B. Schrauben, für die Befestigung zwischen dem Schaltungsträger und der metallischen Gehäusegrundplatte z. B. Nieten. Dies ist aber für eine Fertigung in großer Serie von Nachteil, da unterschiedliche Befestigungsmittel bereitgehalten werden müssen und getrennte Fertigungsschritte erforderlich sind.

### Darstellung der Erfindung

Aufgabe der Erfindung ist es, ein elektrisches Gerät anzugeben, bei dem die mechanische Befestigung zwischen einem Kunststoffsteckerteil, einem plattenförmigen Schaltungsträger und einer metallischen Gehäusegrundplatte möglichst stabil, einfach auszuführen und kostengünstig herzustellen ist.

Diese Aufgabe wird durch ein elektrisches Gerät mit den Merkmalen des Patentanspruchs 1 gelöst. Vorteilhafte Ausgestaltungen der Erfindung sind Gegenstand von abhängigen Ansprüchen.

Die Erfindung geht davon aus, die bei einem Nietvorgang auftretende Flächenpressung durch ein Abstützteil aufzufangen, so dass auch ein Steckerteil aus Kunststoff ohne Beschädigung mit einem Schaltungsträger und einer metallischen Grundplatte vernietet werden kann.

Das erfindungsgemäße elektrische Gerät ist also dadurch gekennzeichnet, dass zur gemeinsamen Befestigung zwischen dem Kunststoffsteckerteil, dem Schaltungsträger und der metallischen Grundplatte Befestigungsmittel vorgesehen sind, die zapfenförmig von der Grundplatte abstehen, bei denen jeweils an einem Endstück dieser Befestigungsmittel, das durch korrespondierende Ausnehmungen im Schaltungsträger und im Kunststoffsteckerteil durchgeführt ist. Am Endstück ist endseitig eine Umformung ausgebildet, die mittels eines Abstützteils am Kunststoffsteckerteil abgestützt ist. Damit ist erreicht, dass die beim Herstellen der Nietverbindung auf das Kunststoffsteckerteil einwirkende Flächenpressung geringer ist. Dadurch wird das Kunststoffsteckerteil beim Herstellen der mechanischen Verbindung weniger stark belastet. Es kommt nicht mehr zur Beschädigung des Kunststoffsteckerteils. Es ist nicht mehr erforderlich, dass bei der Herstellung verschiedene Befestigungsmittel bereit gehalten werden müssen. Damit entfallen auch die getrennten Verfahrensschritte beim Herstellen der Verbindung. Der Herstellungsvorgang ist dadurch einfacher und kann durch ein automatisches Werkzeug erfolgen. Bei der Herstellung wird der Schaltungsträger mit dem darauf angeordneten Kunststoffsteckerteil mittels eines automatischen Handhabungssystems auf die Gehäusegrundplätte so aufgelegt, dass die zapfenförmig abstehenden Befestigungsmittel durch entsprechende Ausnehmungen im Schaltungsträger und im Kunststoffgehäuseteil hindurch ragen. In einem sich daran anschließenden Arbeitsgang wird jeder hindurch gesteckte Deformationsabschnitt kopfseitig verformt, so dass eine stabile Befestigung zwischen dem Kunststoffsteckerteil, dem Schaltungsträger und der Gehäusegrundplatte geschaffen wird. Dies führt zu einer stabilen Befestigung, die auch einer mechanischen Belastung, wie sie bei Betrieb eines KFZ auftritt, gewachsen ist. Die mechanische Belastung der elektrischen Verbindung zwischen den einzelnen Kontakten des Kunststoffsteckerteils und den Leiterbahnen auf dem Schaltungsträger ist dadurch geringer. In Folge davon verbessert sich die Zuverlässigkeit des elektrischen Gerätes. Da die Deformationen der durchgesteckten Verformungsabschnitte in einem Arbeitsvorgang erfolgt, verringern sich die Herstellungskosten. Bei einer Fertigung in Großserie ist dies ein entscheidender Vorteil.

In einer bevorzugten Ausführungsform ist vorgesehen, jedes zapfenförmige Befestigungselement als einen einstückig mit der Grundplatte des Gehäuses hergestellten Nietdom auszubilden. Damit ist jedes Befestigungsmittel integraler Bestandteil der Grundplatte und kann mit dieser in einem Arbeitsvorgang, beispielsweise durch Fließpressen hergestellt werden.

Besonders bevorzugt wird eine Ausführungsform bei der das Abstützteil als Nietbuchse ausgebildet ist, die endseitig einen radial nach außen gerichteten Flansch und an einem zur Grundplatte liegenden Ende einen radial nach innen gerichteten Flansch aufweist. Dadurch wird der Schließkopf des Nietzapfens außenumfangsseitig durch die Buchse umschlossen. Der beim Nieten auftretende Leibungsdruck wird vom weniger stark beanspruchbaren Kunststoff des Steckerteils fern gehalten.

Eine bevorzugte Ausführungsform ist dadurch gekennzeichnet, dass die Nietbuchse in einer Bohrung des Steckerteils reibschlüssig gehalten ist. Dadurch ist die Nietbuchse unverlierbarer Bestandteil des Steckers. Der Stecker wird zusammen mit der Nietbuchse als Zulieferartikel an den Hersteller des elektrischen Gerätes geliefert.

Fertigungstechnisch ist es günstig, wenn die endseitige Verformung der Nietdome in einem Arbeitsgang erfolgt. Wenn der bei der Verformung ausgebildete Schließkopf an dem radial nach innen gerichteten Flansch der Nietbuchse erfolgt, kann bei entsprechender Ausbildung der Nietbuchse die Höhe des Nietdomes gering gehalten werden. Dies ist günstig beim Fließpressen der Nietdome.

Als Material für die Grundplatte kommt bevorzugt eine Aluminiumlegierung zum Einsatz. Die Nietbuchse wird bevorzugt aus einem hochfesten Stahlblech durch Tiefziehen hergestellt.

### Kurzbeschreibung der Zeichnung

Zur weiteren Erläuterung der Erfindung wird im nachfolgenden Teil der Beschreibung auf die Zeichnungen Bezug genommen, aus denen weitere vorteilhafte Ausgestaltungen, Einzelheiten und Weiterbildungen der Erfindung zu entnehmen sind.

Es zeigen:
- Figur 1: ein Steuergerät für ein KfZ in einer Sicht auf das Kunststoffsteckerteil;
- Figur 2: das Steuergerät gemäß Figur 1 in einer Sicht auf die Leiterplatten-Steckkontakte des Kunststoffsteckerteils;
- Figur 3: das Kunststoffsteckerteil mit Blick auf die Öffnung des Steckerschachtes;
- Figur 4: das Kunststoffsteckerteil mit Blick auf die Leiterplatten-Steckkontakte;
- Figur 5a,b: die Befestigung zwischen Kunststoffsteckerteil, Schaltungsträger und Gehäusegrundplatte in einer vergrößerten Darstellung in einem Schnitt;
- Figur 6: die Nietbuchse in einer vergrößerten, dreidimensionalen Darstellung;
- Figur 7: die Gehäusegrundplatte in einer dreidimensionalen Darstellung.

### Ausführung der Erfindung

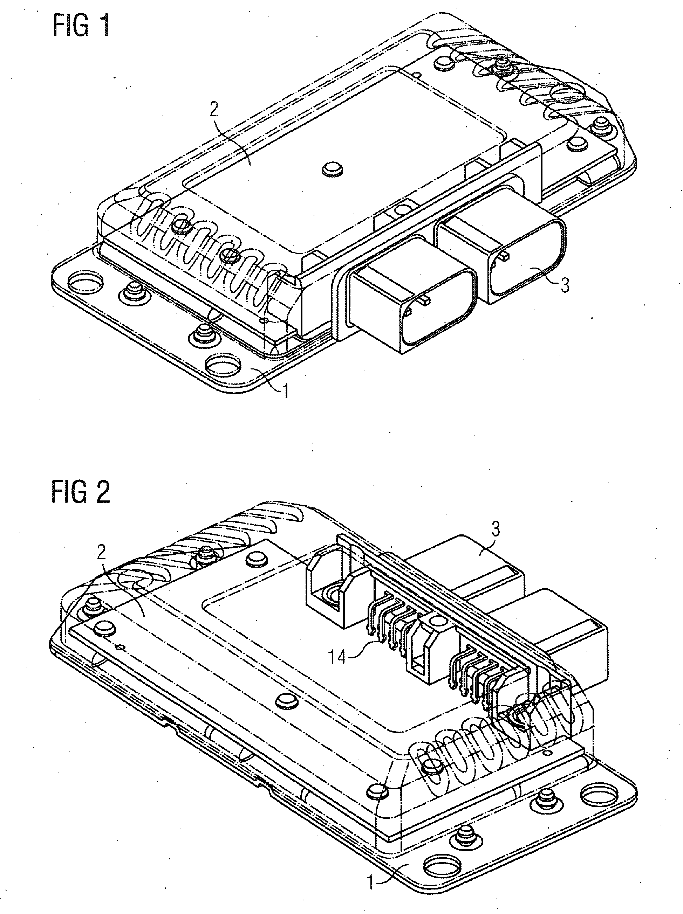

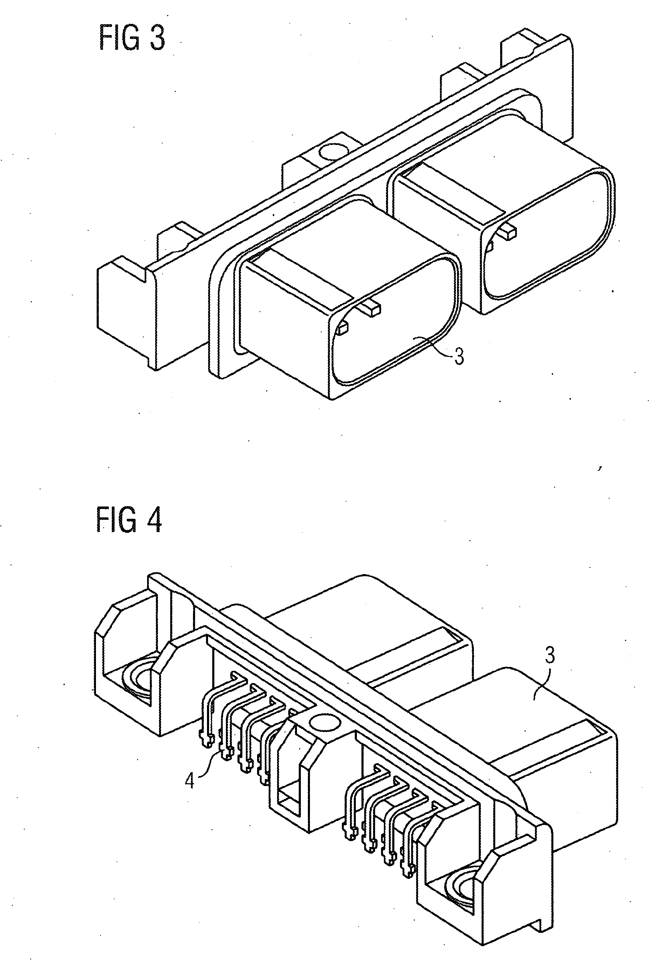

In den Figuren 1 und 2 ist jeweils in einer perspektivischen Ansicht als Ausführungsbeispiel der Erfindung, ein Steuergerät für ein KfZ gezeigt. Auf einer flachen Gehäusegrundplatte 1 ist ein Schaltungsträger 2 befestigt, der durch den transparent dargestellten Gehäusedeckel zu sehen ist. Auf dem Schaltungsträger 2 ist ein Kunststoffsteckerteil 3 befestigt, das in der Figur 3 mit Sicht auf den Steckerschacht dargestellt ist. Die Figur 4 zeigt das Künststoffsteckerteil 3 in einer Sicht auf die Leiterplatten-Steckkontakte 4. Die Leiterplatten-Steckkontakte 4 stellen die elektrische Verbindung zu Leiterbahnen 14 auf dem Schaltungsträger 2 her.

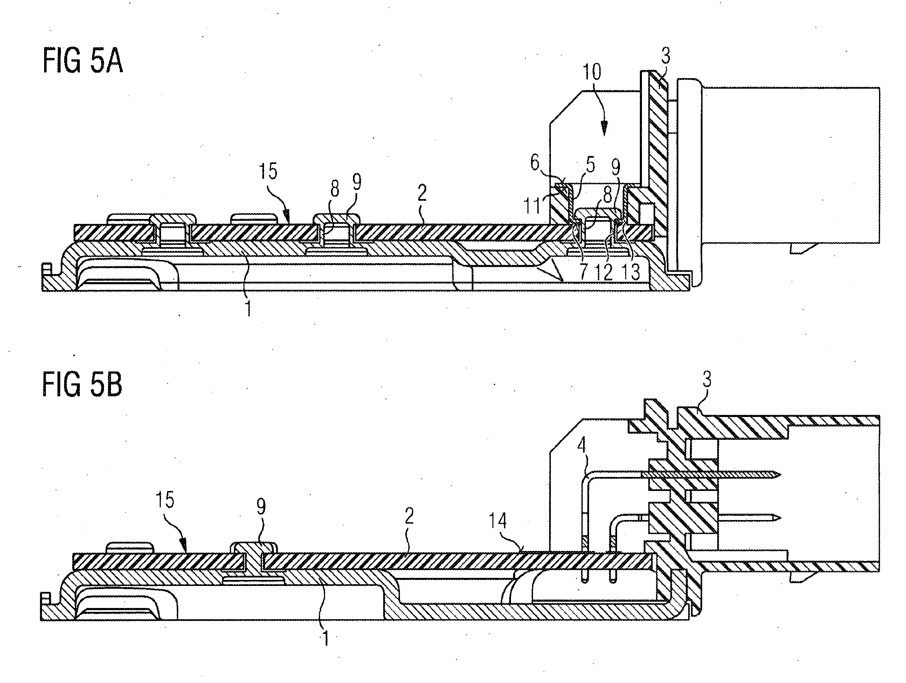

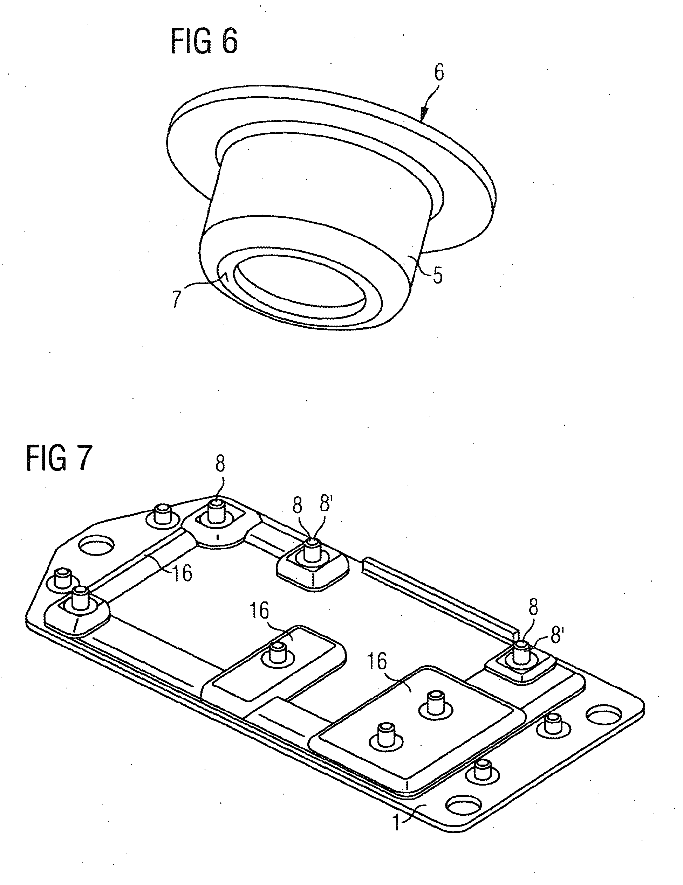

Die Figur 5a und 5b zeigen beispielhaft in einer Schnittzeichnung die Befestigung zwischen dem Kunststoffsteckerteil 3, dem Schaltungsträger 2 und der Gehäusegrundplatte 1. An der Gehäusegrundplatte 1 sind durch Fließpressen hohlzylindrische, dünnwandige Nietdome 8 ausgebildet. Diese Nietdome 8 bilden - wie unten stehend näher erläutert ist - eine mechanische Verbindung zwischen dem Kunststoffgehäuseteil 3, dem Schaltungsträger 2 und der Gehäusegrundplatte 1 bzw. zwischen dem Schaltungsträger 2 und der Gehäusegrundplatte 1. Zur Befestigung des Kunststoffsteckerteil 3 ist jeder Nietdom 8 durch eine korrespondierende Ausnehmung 12 im Schaltungsträger 2 bzw. eine Ausnehmung 13 im Kunststoffsteckerteil 3 durchgesteckt. Wie im linken Teil der Figur 5a und 5b dargestellt, erfolgt auch die Befestigung des Schaltungsträgers 2 auf der Grundplatte 1 durch Nietdome 8 (In Figur 5a und 5b ist nur ein Nietdom 8 gezeichnet). Im zusammengebauten Zustand ist an jedem Ende eines Nietdoms 8 eine ballenförmige Verdickung ausgebildet. Diese Verdickung bildet einen Schließkopf 9 einer Nietverbindung. Die Ausbildung des Schließkopfes 9 erfolgt bei der Herstellung des Steuergerätes für alle Nietdome 8 in einem Arbeitsvorgang. Um zu vermeiden, dass das Kunststoffsteckerteil 3 bei der Ausbildung des Schließkopfes 9 Schaden nimmt, ist erfindungsgemäß ein hohlzylindrisches Abstützteil 5 vorgesehen. Dieses Abstützteil 5 (Fig. 6) besteht aus einer Nietbuchse 5, die aus einem hochfesten Stahl-Blech durch Tiefziehen gefertigt ist. Die Wandstärke beträgt 0,5 mm. Die Nietbuchse 5 ist reibschlüssig in der als Bohrung ausgebildeten Ausnehmung 13 gehalten. Sie ist damit unverlierbar mit dem Steckerteil 3 verbunden, d.h. ein integraler Bestandteil des Kunststoffsteckerteils 3. Das Kunststoffsteckerteil 3 ist durch Spritzgießen gefertigt. Die Nietbuchse 5 kann aber auch zumindest teilweise vom polymeren Werkstoff des Steckerteils 3 umspritzt sein. In diesem Fall wird die Nietbuchse 5 bei der Herstellung des Kunststoffsteckerteils 3 als ein Einlegeteil in das Spritzgusswerkzeug eingelegt. Die Nietbuchse 5 ist im Querschnitt topfförmig mit einem bodenseitigen Loch. Sie weist einen radial nach außen gerichteten Flansch 6 und einen radial nach innen gerichteten Flansch 7 auf (Figur 6). Der radial nach außen gerichtete Flansch 6 stützt sich an einem Ansatz 11 ab, die in einer Eintiefung 10 des Kunststoffsteckerteils 3 ausgebildet ist. Auf dem radial nach innen gerichteten Flansch 7 stützt sich der Schließkopf 9 ab. Durch die topfförmige Ausbildung ist es möglich, dass der endseitige Verformungsabschnitt von jedem Nietdom 8 nach zur Gehäuserundplatte 1 liegt, was die Herstellung durch Kaltfließpressen begünstigt, da die Höhe des Nietdoms 8 klein gehalten werden kann. Beim Herstellen der Nietverbindung wirkt diese Nietbuchse 5 als steifes Anpress-Zwischenteil. Es stellt sicher, dass bei der Herstellung der Nietverbindung weder die angewandten Verformungskräfte noch der Leibungsdruck bei der Ausbildung des Schließkopfes 9 das Kunststoffsteckerteil 3 beschädigen können. Wenn während des Betriebs des Kfz vom Anschlusskabel auf das Kunststoffsteckerteil Vibrationen übertragen werden, so stellt diese mechanische Verbindung sicher, dass die elektrische Verbindung zwischen den Leiterplatten-Steckkontakten 4 des Steckerteils 3 und Leiterbahnen 12 auf der Seite 15 der Leiterplatte 2 nicht beeinträchtigt wird.

Die Figur 7 zeigt für das dargestellte Ausführungsbeispiel die Gehäusegrundplatte 1 in einer perspektivischen Ansicht. An einer Seite der Gehäusegrundplatte 1, die im zusammengebauten Zustand benachbart zum Schaltungsträger 2 liegt, sind zapfenförmig abstehenden Nietdome 8 zu sehen. Diese Nietdome 8 sind im Bereich von sikkenförmigen Ausbuchtungen 16 angeordnet. Diese Ausbuchtungen 16 dienen zur Versteifung der Gehäusegrundplatte 1. Das in Figur 3 und in Figur 4 gesondert dargestellte Kunststoffsteckerteil 3 wird durch zwei gegenüberliegende Nietdome, die in Figur 7 mit dem Bezugszeichen 8' gekennzeichnete sind, befestigt. Die Gehäusegrundplatte 1 ist aus einer Aluminiumlegierung gefertigt. Die Nietdome 8 weisen eine Höhe auf, die größer als der Durchmesser ist, bevorzugt entspricht die Höhe etwa dem 1,5 fachen bis sechsfachen Durchmesser eines Nietdoms 8. Die Nietdome sind durch Fließpressen in einem Arbeitsvorgang zusammen mit der Gehäusegrundplatte 1 hergestellt.
Bei der Herstellung des Steuergerätes wird nun so verfahren, dass auf diese Nietdome 8 der Schaltungsträger 2 samt dem darauf, durch die eingesteckten Leiterplatten-Steckkontakte 4 gehaltenen Kunststoffsteckerteil 3 aufgelegt und durch die Nietdome 8 zentriert wird. In einem sich daran anschließenden Arbeitsschritt erfolgt durch ein automatisches Werkzeug an allen Nietdomen 8 gleichzeitig die endseitige Ausbildung eines Schließkopfes 9. Dadurch entsteht eine feste mechanische Verbindung zwischen dem Kunststoffsteckerteil 3 und dem plattenförmigen Schaltungsträger 2 einerseits und - je nach Anzahl/Anordnung der Nietdome 8 - gleichzeitig eine Nietverbindung zwischen dem Schaltungsträger 2 und der Gehäusegrundplatte 1. Das Kunststoffsteckerteil 3 kann dank der Nietbuchse 5 ohne Schaden zu nehmen vernietet werden. Die Nietbuches 5 ermöglicht es, dass der Schließkopf 9 nahe zur Gehäusegrundplatte 1 liegt. Dadurch kann die Höhe der Nietdome 8 gering gehalten werden, was für das Kaltfließpressen günstig ist.

Die elektrische Verbindung zwischen den Kontakten 4 des Kunststoffsteckerteils 3 und der Leiterbahnen 14 auf dem Schaltungsträger 2 sind weniger störanfällig, da das Kunststoffsteckerteil bei der Ausbildung der Nietverbindung nicht beschädigt wird. Die Zuverlässigkeit des elektrischen Gerätes kann dadurch über eine lange Gebrauchsdauer hoch gehalten werden, auch dann, wenn hohe Beschleunigungskräfte auf das elektrische Gerät einwirken bzw. starke Vibrationen über das Kabel auf den Stecker 3 übertragen werden.

### Zusammenstellung der verwendeten Bezugszeichen

- 1: Gehäusegrundplatte
- 2: Schaltungsträger
- 3: Kunststoffsteckerteil
- 4: Leiterplatten-Steckkontakte
- 5: Abstützteil, Nietbuchse
- 6: Radial nach außen gerichteter Flansch der Nietbuchse
- 7: Radial nach innen gerichteter Flansch den Nietbuchse
- 8: Nietdom (8' in Figur 7)
- 9: Verformung, Schließkopf
- 10: Eintiefung
- 11: Ansatz
- 12: Ausnehmung in 2
- 13: Ausnehmung/Bohrung in 3
- 14: Leiterbahnen
- 15: Seite von 2
- 16: Ausbuchtung auf 1

## Patentansprüche

1. Elektrisches Gerät, insbesondere Steuergerät für ein Kraftfahrzeug, mit einem auf einer metallischen Gehäusegrundplatte (1) befestigten plattenförmigen Schaltungsträger (2) auf dem an einer von der Gehäusegrundplatte (1) abgewandten Seite (15) ein Kunststoffsteckerteil (3) befestigt ist,
**dadurch gekennzeichnet,**
- **dass** zur gemeinsamen Befestigung zwischen dem Kunststoffsteckerteil (3), dem Schaltungsträger (2) und der Gehäuserundplatte (1) Befestigungsmittel (8,9) vorgesehen sind, die zapfenförmig von der Gehäusegrundplatte (1) abstehen,
- **dass** die Befestigungsmittel (8,9) durch korrespondierende Ausnehmungen (12,13) im Schaltungsträger (2) und im Kunststoffsteckerteil (3) durchgeführt sind,
- **dass** an jedem durchgesteckten Ende jeweils eine Verformung (9) ausgebildet ist, und
- **dass** jede Verformung (9) durch ein Abstützteil (5) am Kunststoffsteckerteil (3) abgestützt ist.

2. Elektrisches Gerät nach Anspruch 1, **dadurch gekennzeichnet, dass** die zapfenförmigen Befestigungselemente (8) einstückig mit der Gehäusegrundplatte (1) ausgebildet sind.

3. Elektrisches Gerät nach Anspruch 2, **dadurch gekennzeichnet, dass** jedes Befestigungselement (8) als Nietdom ausgebildet ist, der durch Fließpressens der Gehäusegrundplatte (1) hergestellt ist.

4. Elektrisches Gerät nach einem der Ansprüche 1 bis 3, **dadurch gekennzeichnet, dass** das Abstützteil (5) als Nietbuchse ausgebildet ist, die an einem von der Gehäusegrundplatte (1) abgewandten Ende einen radial nach außen gerichteten Flansch (6) und an einem der Gehäusegrundplatte (1) zugewandten Ende einen radial nach innen gerichteten Flansch (7) aufweist.

5. Elektrisches Gerät nach Anspruch 4, **dadurch gekennzeichnet, dass** die Ausnehmung (13) im Kunststoffsteckerteil (3) durch eine in einer Eintiefung (10) ausgebildeten Bohrung (13) gebildet ist, dass der radial nach außen gerichtete Flansch (6) an einem Ansatz (11) der Bohrung abgestützt ist und die Nietbuchse (5) in dieser Bohrung (13) reibschlüssig gehalten ist.

6. Elektrisches Gerät nach Anspruch 5, **dadurch gekennzeichnet, dass** die endseitige Verformung (9) als ballenförmiger Schließkopf ausgebildet ist, der an dem radial nach innen gerichteten Flansch (7) der Nietbuchse (5) abgestützt ist.

7. Elektrisches Gerät nach Anspruch 6, **dadurch gekennzeichnet, dass** jeder Schließkopf (9) jedes Nietdomes (8) der Gehäusegrundplatte (1) in einem Arbeitsgang hergestellt wird.

8. Elektrisches Gerät nach Anspruch 7, **dadurch gekennzeichnet, dass** jeder Nietdom (8) eine Höhe aufweist, die größer als ein Durchmesser eines Nietdoms (8) ist, besonders bevorzugt eine Höhe die etwa 1,5-Mal so groß wie der Durchmesser eines Nietdoms (8) ist.

9. Elektrisches Gerät nach Anspruch 8, **dadurch gekennzeichnet, dass** die Gehäusegrundplatte (1) als Fließpressteil aus einer Aluminiumlegierung, besonders bevorzugt einer Aluminium-Magnesium-Legierung hergestellt ist.

10. Elektrisches Geräte nach einem der vorstehenden Ansprüche, **dadurch gekennzeichnet, dass** das Abstützteil (5) zumindest abschnittsweise von polymeren Werkstoff des Kunststoffsteckerteils (3) eingebettet ist.

11. Elektrisches Gerät nach Anspruch 10, **dadurch gekennzeichnet, dass** das Abstützteil (5) aus einem hochfesten Stahl gefertigt ist.

## Claims

1. Electrical device, in particular control device for a motor vehicle, having a plate-like circuit mount (2) which is fixed on a metal housing base plate (1) and on which a plastic plug part (3) is fixed on a side (15) which is averted from the housing base plate (1),
**characterized**
- **in that** fixing means (8, 9) are provided for common fixing between the plastic plug part (3), the circuit mount (2) and the housing base plate (1), the said fixing means projecting from the housing base plate (1) in the manner of a pin,
- **in that** the fixing means (8, 9) are passed through corresponding openings (12, 13) in the circuit mount (2) and in the plastic plug part (3),
- **in that** a deformed portion (9) is in each case formed at each end which is pushed through,
- **in that** each deformed portion (9) is supported on the plastic plug part (3) by a support part (3).

2. Electrical device according to Claim 1, **characterized in that** the pin-like fixing elements (8) are integrally formed with the housing base plate (1).

3. Electrical device according to Claim 2, **characterized in that** each fixing element (8) is in the form of a rivet dome which is produced by extruding the housing base plate (1).

4. Electrical device according to one of Claims 1 to 3, **characterized in that** the support part (5) is in the form of a rivet bushing which has a flange (6) which is directed radially outward at an end which is averted from the housing base plate (1), and has a flange (7) which is directed radially inward at an end which faces the housing base plate (1).

5. Electrical device according to Claim 4, **characterized in that** the opening (13) in the plastic plug part (3) is formed by a bore (13) which is formed in a recess (10), **in that** the flange (6) which is directed radially outward is supported on a projection (11) of the bore and the rivet bushing (5) is held in this bore (13) with a frictional connection.

6. Electrical device according to Claim 5, **characterized in that** the deformed portion (9) at the end is in the form of a ball-like closing head which is supported on the flange (7) of the rivet bushing (5), which flange is directed radially inward.

7. Electrical device according to Claim 6, **characterized in that** each closing head (9) of each rivet dome (8) of the housing base plate (1) is produced in one working step.

8. Electrical device according to Claim 7, **characterized in that** each rivet dome (8) has a height which is greater than a diameter of a rivet dome (8), particularly preferably a height which is approximately 1.5 times the size of the diameter of a rivet dome (8).

9. Electrical device according to Claim 8, **characterized in that** the housing base plate (1) is produced as an extruded part from an aluminium alloy, particularly preferably an aluminium/magnesium alloy.

10. Electrical device according to one of the preceding claims, **characterized in that** the support part (5), at least in sections, is embedded in polymeric material of the plastic plug part (3).

11. Electrical device according to Claim 10, **characterized in that** the support part (5) is manufactured from a high-strength steel.

## Revendications

1. Appareil électrique, notamment appareil de commande, comprenant un support ( 2 ) de circuit en forme de plaque, qui est fixé à une plaque ( 1 ) de base métallique de boîtier et sur lequel un bloc ( 3 ) enfichable en matière plastique est fixé sur une face ( 15 ) éloignée de la plaque ( 1 ) de base de boîtier,
**caractérisé**
- **en ce que**, pour la fixation conjointe entre le bloc ( 3 ) enfichable en matière plastique, le support ( 2 ) de circuit et la plaque ( 1 ) de base de boîtier, il est prévu des moyens ( 8, 9 ) de fixation, qui font saillie en forme de tenon de la plaque ( 1 ) de base de boîtier,
- **en ce que** les moyens ( 8, 9 ) de fixation passent dans des évidements ( 12, 13 ) correspondant du support ( 2 ) de circuit et du bloc ( 3 ) enfichable en matière plastique,
- **en ce que** à chaque extrémité enfichée est formée respectivement une déformation ( 9 ), et
- **en ce que** chaque déformation ( 9 ) est supportée par une partie ( 9 ) d'appui sur le bloc ( 3 ) enfichable en matière plastique.

2. Appareil électrique suivant la revendication 1, **caractérisé en ce que** les éléments ( 8 ) de fixation en forme de tenon sont en une seule pièce avec la plaque ( 1 ) de base de boîtier.

3. Appareil électrique suivant la revendication 2, **caractérisé en ce que** chaque élément ( 8 ) de fixation est constitué sous la forme d'un dôme de rivet qui est produit par l'extrusion de la plaque ( 1 ) de base de boîtier.

4. Appareil électrique suivant l'une des revendications 1 à 3, **caractérisé en ce que** la partie ( 5 ) d'appui est constituée sous la forme d'un fût de rivet, qui a, à une extrémité éloignée de la plaque ( 1 ) de base de boîtier, une bride ( 6 ) dirigée radialement vers l'extérieur et, à une extrémité tournée vers la plaque ( 1 ) de base de boîtier, une bride ( 7 ) dirigée radialement vers l'intérieur.

5. Appareil électrique suivant la revendication 4, **caractérisé en ce que** l'évidement ( 13 ) est formé dans le bloc ( 3 ) enfichable en matière plastique par un trou ( 13 ) formé dans un creusement ( 10 ), **en ce que** la bride ( 6 ) dirigée radialement vers l'extérieur s'appuie sur un épaulement ( 11 ) du trou et le fût ( 5 ) de rivet est maintenu par frottement dans ce trou ( 13 ).

6. Appareil électrique suivant la revendication 5, **caractérisé en ce que** la déformation ( 9 ) du côté de l'extrémité est constituée sous la forme d'une tête de fermeture en forme de bille, qui s'appuie sur la bride ( 7 ) du fût ( 5 ) de rivet dirigée radialement vers l'intérieur.

7. Appareil électrique suivant la revendication 6, **caractérisé en ce que** chaque tête ( 9 ) de fermeture de chaque dôme de rivet de la plaque ( 1 ) de base de boîtier est fabriquée en une passe opératoire.

8. Appareil électrique suivant la revendication 7, **caractérisé en ce que** chaque dôme ( 8 ) de rivet a une hauteur plus grande qu'un diamètre d'un dôme ( 8 ) de rivet en ayant, d'une manière particulièrement préférée, une hauteur qui représente à peu près 1,5 fois le diamètre d'un dôme ( 8 ) de rivet.

9. Appareil électrique suivant la revendication 8, **caractérisé en ce que** la plaque ( 1 ) de base de boîtier est produite sous la forme d'une pièce extrudée en un alliage d'aluminium, d'une manière particulièrement préférée en un alliage d'aluminium et de magnésium.

10. Appareil électrique suivant l'une des revendications précédentes, **caractérisé en ce que** la partie ( 5 ) d'appui est incorporée au moins par tronçon dans du matériau polymère du bloc ( 3 ) enfichable en matière plastique.

11. Appareil électrique suivant la revendication 10, **caractérisé en ce que** la partie ( 5 ) d'appui est en un acier très résistant.
